## Europäisches Patentamt

## European Patent Office

## Office européen des brevets

(19)

(11) Veröffentlichungsnummer: **0 205 644**
**B1**

(12) **EUROPÄISCHE PATENTSCHRIFT**

(45) Veröffentlichungstag der Patentschrift:
**22.06.88**

(51) Int. Cl.⁴: **H 01 L 21/306**, H 01 L 21/60

(21) Anmeldenummer: **85107887.3**

(22) Anmeldetag: **25.06.85**

(54) **Verfahren zum Herstellen von Kontaktöffnungen in auf Halbleitermaterial angeordneten Isolierschichten.**

(43) Veröffentlichungstag der Anmeldung:
**30.12.86 Patentblatt 86/52**

(45) Bekanntmachung des Hinweises auf die Patenterteilung:
**22.06.88 Patentblatt 88/25**

(84) Benannte Vertragsstaaten:
**DE FR NL**

(56) Entgegenhaltungen:
**EP - A - 0 015 403**

**JOURNAL OF THE ELECTROCHEMICAL SOCIETY, Band 128, Nr. 1, Januar 1981, Seiten 123-126, Manchester, New Hampshire, US; K.M. EISELE: "SF6, a preferable etchant for plasma etching silicon"**
**JOURNAL OF THE ELECTROCHEMICAL SOCIETY, Band 130, Nr. 8, August 1983, Seite 318C, Zusammenfassung Nr. 205, Manchester, New Hampshire, US; G.C. EIDEN et al.: "Reactive ion etching of silicon in an RF discharge of sulfur hexafluoride"**
**JOURNAL OF APPLIED PHYSICS, Band 56, Nr. 4, 15. August 1984, Seiten 1195-1198, American Institute of Physics, New York, US; W.W. BRANDT et al.: "Studies of product layers formed during etching of Si in a SF6 plasma"**

(73) Patentinhaber: **Deutsche ITT Industries GmbH, Hans-Bunte-Strasse 19 Postfach 840, D-7800 Freiburg (DE)**

(72) Erfinder: **Lacher, Manfred, Am See 10, D-7803 Gundelfingen (DE)**
Erfinder: **Prüfer, Gerd, Dr., Bundesstrasse 70, D-7803 Gundelfingen (DE)**

(74) Vertreter: **Morstadt, Volker, Dipl.-Ing., c/o Deutsche ITT Industries GmbH Patent/Lizenzabteilung Postfach 840 Hans-Bunte-Strasse 19, D-7800 Freiburg/Brsg. (DE)**

# Beschreibung

Die Erfindung betrifft ein Verfahren nach dem Oberbegriff des Anspruchs 1, wie es in der US-PS 3 795 557 beschrieben ist.

Mit zunehmender Integrationsdichte integrierter Schaltungen und dem damit verbundenen Übergang zu immer feineren Strukturen treten Probleme hinsichtlich der Herstellung von Öffnungen durch Ätzen auf. So kommt es z.B. beim Nassätzen von der Kontaktierung dienenden Öffnungen in Isolierschichten aus Siliciumdioxid zum Unterätzen der Ätzmasken. Das Problem konnte durch den Übergang zu geeigneten Trockenätzverfahren, und zwar insbesondere durch die Anwendung des reaktiven Ionenätzens (RIE), überwunden werden.

Mit reaktiven Ionenätzverfahren (RIE-Verfahren) erhält man ein anisotropes Ätzverhalten, das bedeutet vertikale Ätzwände ohne Unterätzen der Maske. (Siehe «J. Vac. Sci. Techn.» Sept./Oct. 1980, Seiten 1177 bis 1183, insbesondere Seite 1179).

Bei gebräuchlichen RIE-Verfahren zum Ätzen von Kontaktlöchern in Isolierschichten aus Siliciumdioxid oder Siliciumnitrid finden halogenierte Kohlenwasserstoffe Verwendung.

Solche Prozesse bewirken jedoch eine Veränderung der zu kontaktierenden Halbleiteroberflächen, d.h. der Oberfläche von mono- oder polykristallinem Silicium, (siehe hierzu EP-A1 0 036 144). Bei der Herstellung von metallischen Zuleitungen, z.B. elektrischen Zwischenverbindungen aus Aluminium, ergibt sich dadurch ein stark erhöhter Kontaktwiderstand, der zum Ausfall der integrierten Schaltungen führt.

Die vorliegende Erfindung, wie sie in den Ansprüchen gekennzeichnet ist, löst die Aufgabe, ein RIE-Verfahren anzugeben, mit dem Kontaktöffnungen hergestellt werden können, die nach der Metallisierung im Vergleich zum Nassätzen keinen erhöhten Kontaktwiderstand haben.

Die Vorteile der Erfindung liegen in der Lösung der Aufgabe selbst sowie in der damit verbundenen Verbesserung der Ausbeute an integrierten Schaltungen.

In der EP-A1 0 015 403 ist zwar beschrieben, das reaktive Ionenätzen von Silicium in Öffnungen einer Isolierschicht aus Siliciumdioxid und/oder Siliciumnitrid mit einer schwefelhexafluoridhaltigen Gasmischung, nämlich Schwefelhexafluorid + Chlor + Inertgas, durchzuführen. In der bereits erwähnten EP-A1 0 036 144 ist jedoch auch angegeben, dass sich dabei eine Oberflächenverunreinigung des Siliciums durch Schwefel ergibt. Ferner ist es aus der Druckschrift Journal of the Electochemical Society vol 128 no 1, Seiten 123-126 bekannt, ein Gasgemisch aus Schwefelhexafluorid und Argon zum Plasmaätzen von Silicium zu verwenden, ohne dass eine Oberflächenverunreinigung entsteht. Wie die Erfinder erkannt haben, lässt sich jedoch mit dem angegebenen Verfahren die während des Ätzens der Isolierschichten mit halogenierten Kohlenwasserstoffen entstehende, unter anderem mit Kohlenstoff verunreinigte Oberflächenschicht des Siliciums beseitigen, ohne dass die Siliciumoberfläche durch Schwefel wieder verunreinigt wird.

Die Erfindung wird nachstehend anhand eines Ausführungsbeispiels näher erläutert.

In und an einer Halbleiterscheibe werden nach einem herkömmlichen Verfahren integrierte Schaltungen hergestellt. Nach Aufbringen einer Isolierschicht aus Siliciumdioxid oder Siliciumnitrid und einer Photomaske wird nach deren Strukturierung der Ätzprozess zur Herstellung von Kontaktöffnungen in einer herkömmlichen RIE-Anlage (13,6 MHz) durchgeführt. Dabei wird zunächst mit einem Gasgemisch aus halogeniertem Kohlenwasserstoff, vorzugsweise Trifluormethan, und Sauerstoff im Verhältnis 3 : 1 die Isolierschicht aus vorzugsweise Siliciumdioxid und/oder Siliciumnitrid anisotrop bis zur Oberfläche des zu kontaktierenden Halbleitermaterials durchgeätzt. Anschliessend wird in derselben Ätzanlage in einem weiteren Ätzprozess mit einem Gasgemisch aus Schwefelhexafluorid und einem Edelgas, vorzugsweise Argon, die Oberfläche des freigelegten Halbleitermaterials geätzt, wobei das Mengenverhältnis von Schwefelhexafluorid zu Edelgas vorzugsweise 1 : 12,5 beträgt. Bei einem Gasdurchfluss von 54 ml/min, einem Druck von 67 Pa und einer Hochfrequenzleistung von 500 W ergibt sich für monokristallines Silicium eine Ätzrate von angenähert 10 nm/min. Zur Erzielung eines ausreichend niedrigen Kontaktwiderstandes erwies sich eine Ätzzeit von 1,5 min als ausreichend.

## Patentansprüche

1. Verfahren zum Herstellen von Kontaktöffnungen in aus Siliciumdioxid und/oder Siliciumnitrid bestehenden und auf einem Halbleitermaterial angeordneten Isolierschichten durch reaktives Ionenätzen mittels eines Gasgemisches aus einem halogenierten Kohlenwasserstoff und Sauerstoff, dadurch gekennzeichnet, dass mit einem anderen Gasgemisch aus Schwefelhexafluorid und einem Edelgas im Mischungsverhältnis Schwefelhexafluorid zu Edelgas von mindestens 1 : 10 die freigelegte Oberfläche des Halbleitermaterials angeätzt wird.

2. Verfahren nach Anspruch 1, dadurch gekennzeichnet, dass als Edelgas Argon verwendet wird.

3. Verfahren nach Anspruch 1 oder 2, dadurch gekennzeichnet, dass bei einer Hochfrequenzleistung von 500 W, einer Gasdurchflussmenge von ca. 50 ml/min und einem Gesamtgasdruck von ca. 70 Pa gearbeitet wird.

4. Verfahren nach einem der Ansprüche 1 bis 3, dadurch gekennzeichnet, dass die beiden Ätzschritte in derselben Ätzanlage durchgeführt werden.

## Claims

1. Method of manufacturing contact window openings in insulating layers consisting of silicon dioxide and/or silicon nitride and disposed on a semiconducting material, by employing reactive-ion etching using a gas mixture of a halogenized hydrocarbon and oxygen, characterized in that by using another gas mixture of sulphurhexafluoride and a noble gas at a mixture of sulphurhexafluoride to noble gas of at least 1 : 10, the exposed surface of the semiconducting material is etched only slightly or superficially.

2. A method as claimed in claim 1, characterized in that argon is used as said noble gas.

3. A method as claimed in claim 1, characterized in that the operation is carried out at a high-frequency power of 500 W, a quantitative gas flowrate of about 50 ml/min, and a total gas pressure of about 70 Pa.

4. A method as claimed in one of claims 1 to 3, characterized in that said two etchsteps are carried out in one and the same etching equipment (etcher).

## Revendications

1. Procédé de formation d'ouvertures de contact dans des couches isolantes constituées de dioxyde de silicium et/ou de nitrure de silicium et agencées sur un matériau semi-conducteur, par attaque ionique réactive au moyen d'un mélange gazeux composé d'un hydrocarbure halogéné et d'oxygène, caractérisé en ce qu'en utilisant un autre mélange gazeux composé d'hexafluorure de soufre et d'un gaz rare dans la proportion d'hexafluorure de soufre par rapport au gaz rare d'au moins 1/10, la surface exposée du matériau semi-conducteur est attaquée seulement légèrement ou superficiellement.

2. Procédé selon la revendication 1, caractérisé en ce que de l'argon est ulitisé comme gaz rare.

3. Procédé selon l'une quelconque des revendications 1 ou 2, caractérisé en ce que l'opération est réalisée avec une puissance haute fréquence de 500 W, un débit de gaz d'environ 50 ml/min et une pression globale du gaz d'environ 70 Pa.

4. Procédé selon l'une quelconque des revendications 1 à 3, caractérisée en ce que les deux phases de l'attaque sont réalisées dans la même installation d'attaque.